# FASCICULE DE BREVET EUROPEEN

(11) **EP 3 544 120 B1**
(45) Date de publication et mention de la délivrance du brevet: **24.02.2021**
(21) Numéro de dépôt: 19164683.5
(22) Date de dépôt: 22.03.2019
(51) Int. Cl.: H01R 9/26, H02B 1/16, H05K 9/00, H02B 1/052

(54) **EQUIPEMENT ÉLECTRIQUE ET PROCÉDÉ DE MISE À LA TERRE POUR UN TEL ÉQUIPEMENT**
ELEKTROGERÄT UND ERDUNGSVERFAHREN FÜR EIN SOLCHES GERÄT
ELECTRICAL EQUIPMENT AND METHOD FOR EARTHING SUCH EQUIPMENT

(30) Priorité: 23.03.2018 FR 1852538
(43) Date de publication de la demande: 25.09.2019
(73) Titulaire: Schneider Electric Industries SAS, 92500 Rueil Malmaison (FR)
(72) Inventeur: BOUCHARD, Jean-Luc, 38050 GRENOBLE Cedex 09 (FR); FILIPPENKO, Konstantin, 38050 GRENOBLE Cedex 09 (FR); LACROIX, Stéphane, 38050 GRENOBLE Cedex 09 (FR)
(74) Mandataire: Lavoix

(56) Documents cités:
- DE-A1- 3 526 494
- DE-B3- 10 249 981
- FR-A1- 2 786 941

## Description

L'invention a trait à un équipement électrique tel qu'un contacteur qui comprend, entre autres, un module de contrôle et/ou de commande qui inclut une carte de circuit imprimé supportant des composants électroniques.

Ces composants doivent être protégés contre les perturbations électromagnétiques dues à l'environnement, en particulier dans le cas où des courants d'intensité relativement importante passent par des conducteurs électriques situés au voisinage du module de contrôle et/ou de commande.

Dans la majorité des produits connus, une mise à la terre est réalisée au moyen d'une borne spécifique prévue sur l'équipement électrique et d'un câble de raccordement de cette borne à une prise de terre, à l'extérieur de ce matériel. Ce câble n'est pas intégré au produit en question et risque d'être endommagé en cours d'utilisation de l'équipement électrique.

Par ailleurs, WO-A-2011/041413 divulgue une mise à la terre commandée d'un matériel électrique monté sur un rail DIN, au moyen d'une came rotative qui commande un feuillard de section rectangulaire, afin de l'amener sélectivement en appui contre une partie d'un module à mettre à la terre. La mise à la terre résulte d'une action positive d'un opérateur qui doit manipuler la came. En cas d'oubli de la part de l'opérateur, le matériel n'est pas mis à la terre. Son fonctionnement peut être altéré, voire dangereux.

EP-A-1 073 323 divulgue, quant à lui, le principe d'une platine de fixation métallique d'un équipement électrique sur un rail support. Un organe élastique de blocage de cette platine sur le rail est prévu. Il est en résine et ne participe pas à la mise à la terre d'une partie de ce dispositif. L'utilisation d'une platine métallique complète, disposée sur l'arrière du composant, induit une consommation importante de métal, ce qui peut présenter du sens dans le cas où une fonction de dissipation de chaleur est recherchée, comme dans cet art antérieur, mais pas en l'absence d'une telle fonction.

EP-A-2 685 564 prévoit de souder une patte conductrice sur une carte de circuit imprimé, afin de mettre une partie de cette carte à la terre. Compte tenu des vibrations subies par un équipement électrique au cours de sa durée de vie, il existe un risque de rupture de la soudure, d'où une perte du contact de masse. Ce risque est d'autant plus marqué pour les contacteurs électriques du fait des vibrations résultant de leurs ouvertures fermetures successives.

FR-A-2786941 divulgue l'utilisation d'une lame conductrice et d'un fil électrique pour mettre à la masse une partie d'un appareil électrique. La lame conductrice n'agit pas directement sur les bornes d'une carte de circuit imprimé et présente une forme peu adaptée à un contact électrique pérenne Le document DE10249981 décrit un équipement selon le préambule de la revendication 1.

La présente invention vise à résoudre ces problèmes en proposant une nouvelle structure d'équipement électrique dans laquelle une mise à la terre efficace est obtenue, sans risque d'oubli de la part d'un utilisateur, grâce à des moyens fiables et économiques, et sans risque de rupture d'une liaison soudée, ce qui permet de protéger des composants électroniques montés sur une carte de circuit imprimé d'un module de contrôle et/ou de commande vis-à-vis des perturbations électromagnétiques dues à l'environnement de l'équipement électrique.

A cet effet, l'invention concerne un équipement électrique comprenant un boîtier destiné à être monté sur un rail et un module de contrôle et/ou de commande qui inclut une carte de circuit imprimé. Conformément à l'invention, en configuration montée de l'équipement électrique sur le rail, au moins une borne de masse de la carte de circuit imprimé est raccordée électriquement au rail, en permanence, par appui mécanique élastique et contact électrique direct avec un élément de raccordement, lui-même en appui mécanique élastique et contact électrique direct avec le rail ou avec un organe de blocage élastique du boîtier sur le rail.

Grâce à l'invention, la mise en place du boîtier sur le rail permet de raccorder électriquement la borne de masse de la carte de circuit imprimé avec ce rail qui, conformément aux normes en vigueur, est lui-même mis à la masse. Ainsi, le simple montage de l'équipement électrique sur le rail permet de mettre à la terre la borne correspondante de la carte de circuit imprimé, sans intervention spécifique de l'opérateur et sans renchérir notablement le prix de revient de l'équipement électrique conforme à l'invention. L'élément de raccordement est une agrafe conductrice semi-rigide constituée par un fil métallique conformé pour relier électriquement la borne de masse et le rail.

Au sens de la présente invention, deux pièces sont en appui l'une contre l'autre quand elles sont en contact direct, sans interposition d'une pièce intermédiaire. En outre, une pièce est conductrice quand elle conduit un courant, dans la gamme de tension et d'ampérage d'utilisation de l'équipement électrique. Typiquement, une pièce conductrice a une résistivité inférieure ou égale à 0,20 Ω.mm²/m.

Au sens de l'invention, un contact électrique est direct lorsqu'il a lieu sans interposition de matière entre les deux pièces en contact.

Selon des aspects avantageux mais non obligatoires de l'invention, un tel équipement électrique peut incorporer une ou plusieurs des caractéristiques suivantes, prises selon toute combinaison techniquement admissible :
- L'agrafe conductrice semi-rigide comprend une première portion d'appui élastique contre la borne de masse de la carte de circuit imprimé, cette première portion comprenant deux branches qui s'étendent à partir d'un coude de jonction.
- La première portion d'appui élastique est reçue et guidée, parallèlement à sa longueur, dans un logement défini entre le boîtier et la carte de circuit imprimé.
- L'organe de blocage élastique est un ressort spirale prévu pour venir en appui contre le rail, alors que l'élément de raccordement électrique est une agrafe conductrice en appui, d'une part, sur la borne de masse et, d'autre part, sur le ressort spiral.
- L'agrafe conductrice est monobloc et conformée pour relier électriquement la borne de masse de la carte de circuit imprimé et le ressort spirale.
- L'agrafe conductrice comprend une deuxième portion d'appui élastique sur le ressort spiral, cette deuxième portion comprenant deux branches qui s'étendent à partir d'un coude de jonction.
- Le fil métallique de l'agrafe conductrice semi-rigide est monobloc et comprend au moins une première portion d'appui contre la borne de masse de la carte de circuit imprimé, une deuxième portion d'appui direct le rail et une troisième portion de liaison entre les première et deuxième portions.
- Le fil métallique de l'agrafe conductrice semi-rigide comprend deux premières portions d'appui contre une borne de la carte de circuit imprimé, alors que la deuxième portion de ce fil comprend un barreau d'appui mécanique élastique direct sur le rail et que- la troisième portion de ce fil relie entre elles les deux premières portions et la deuxième portion.
- L'agrafe conductrice semi-rigide est réalisée dans un fil de bronze avec une section transversale dont l'aire est comprise entre 0,5 et 4 mm².

Selon un autre aspect, l'invention vise un procédé de mise à la terre d'une carte de circuit imprimé d'un module de contrôle et/ou de commande d'un équipement électrique qui peut être tel que mentionné ci-dessus et qui comprend un boîtier destiné à être monté sur un rail. Conformément à l'invention, la mise à la terre est effectuée par le seul montage du boîtier sur le rail.

L'invention sera mieux comprise et d'autres avantages de celle-ci apparaîtront plus clairement à la lumière de la description qui va suivre, de deux modes de réalisation d'un équipement électrique et d'un procédé de mise à la terre conformes à son principe, donnée uniquement à titre d'exemple et faite en référence aux dessins annexés dans lesquels :
- la figure 1 est une vue en perspective d'une partie d'une installation électrique comprenant plusieurs équipements électriques conformes à l'invention ;
- la figure 2 est une coupe en perspective d'un contacteur de cette installation, selon le plan II à la figure 1 ;
- la figure 3 est une vue en perspective partielle, selon un autre angle et par l'arrière, du module représenté en coupe à la figure 2, dont le boîtier a été omis pour la clarté du dessin, et du rail associé ;
- la figure 4 est une vue à plus grande échelle de certaines parties correspondant au détail D à la figure 3, vues sous un autre angle, l'objet de la figure 3 étant coupé suivant le plan IV sur cette figure ;
- la figure 5 est une vue en perspective d'un organe de contact électrique utilisé dans l'équipement électrique des figures 2 à 4 ;
- la figure 6 est une coupe en perspective d'un autre contacteur de l'installation de la figure 1, selon le plan VI à la figure 1 ;
- la figure 7 est une vue en perspective par l'arrière de certaines parties du contacteur de la figure 6 et du rail associé et
- la figure 8 est une vue en perspective d'un organe de raccordement électrique utilisé dans le contacteur des figures 6 et 7.

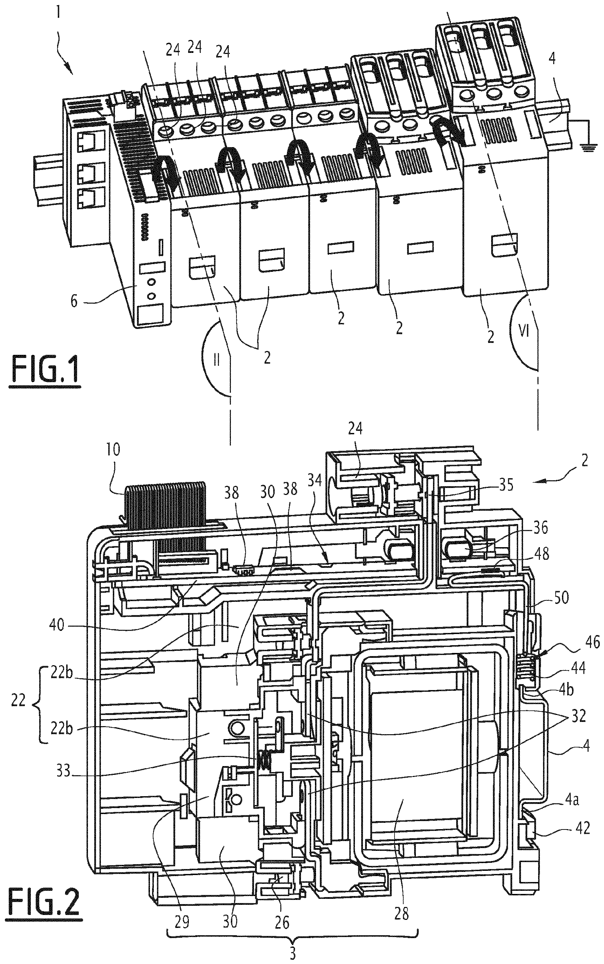

L'installation 1 partiellement représenté à la figure 1 comprend plusieurs départs moteurs 2, parfois dénommés « starters », qui forment des équipements électriques montés sur un rail DIN 4. Ces équipements 2 peuvent être de plusieurs types, en fonction de l'intensité nominale du courant qu'ils permettent de laisser passer.

L'installation 1 comprend également un coupleur de bus 6. Les équipements 2 et 6 sont reliés entre eux par une nappe non représentée de fils conducteurs qui forment un bus de contrôle des matériels 2 et 6, ce bus étant représenté par des flèches sur cette figure 1. La nappe de fils conducteurs de commande est partiellement visible aux figures 2, 3 et 7, avec la référence 10.

Les équipements 2 peuvent être de types différents, en fonction de la valeur maximum du courant qu'ils permettent de faire passer ou de couper. Par exemple, à la figure 1, les deux premiers équipements 2 en partant de la gauche sont des contacteurs d'un premier modèle, permettant de couper ou de laisser passer un courant dont l'intensité nominale est comprise entre 0 et 45 ampères (A). Le cinquième équipement 2 en partant de la gauche est un contacteur d'un deuxième modèle, permettant de couper ou de laisser passer un courant entre 45 et 80A. Les troisième et quatrième équipements 2 en partant de la gauche sont des modules de mesure permettant de piloter indirectement des charges électriques. Ces troisième et quatrième équipements ne comprennent pas d'organe de coupure, de type contacteur ou équivalent. Le troisième équipement 2 peut laisser passer un courant de 0 à 45A. Le quatrième équipement 2 peut laisser passer un courant de 45 à 80A.

Comme cela ressort de la figure 2, le premier départ moteur 2 en partant de la gauche à la figure 1 comprend un boîtier 22 en matériau électriquement isolant pour les tensions et courant de fonctionnement normal de cet équipement, par exemple en matériau synthétique thermoplastique, notamment en PA6.

L'équipement 2 inclut un contacteur 3, qui est un produit connu en soi, et qui comprend, d'une part, un électroaimant 28 et, d'autre part, un châssis isolant 29 dans lequel circulent trois lignes conductrices, dont une seule est visible à la figure 2, avec la référence 32. Cette ligne conductrice 32 comprend également une palette 33 mobile dans le châssis 29 sous l'action de l'électroaimant 28. L'électroaimant 28 commande simultanément le déplacement des trois palettes 33. Deux bornes 30 sont prévues sur le châssis 29 pour le branchement de câbles d'alimentation de l'électroaimant 28, lesquels ne sont pas représentés.

L'équipement 2 comprend trois bornes d'entrée de câbles 24 situées en partie supérieure, comme visibles aux figures 1 et 2, ainsi que trois bornes de sortie, dont une seule est visible à la figure 2, avec la référence 26. Chaque ligne de courant 32 s'étend entre une borne 24 et une borne 26.

L'électroaimant 28 et les lignes conductrices 32 sont montés dans le boîtier 22. Ils permettent d'interrompre sélectivement une liaison électrique formée entre les bornes 24 et 26, cette liaison électrique comprenant les lignes conductrices 32 du châssis 29 et des pattes de raccordement qui circulent dans le boîtier 22, dont une seule est visible à la figure 2 avec la référence 35.

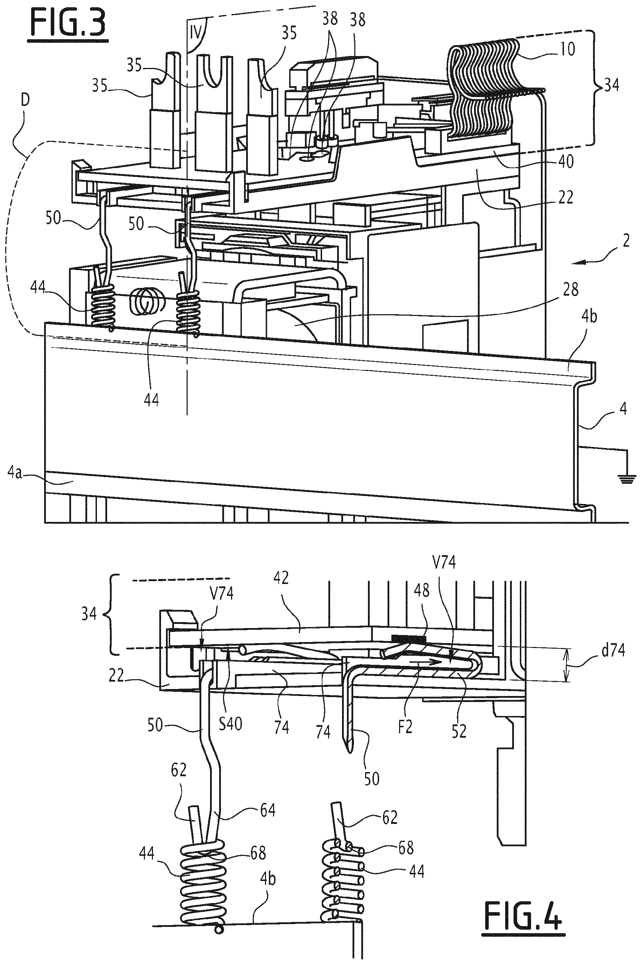

Le boîtier 22 renferme également un module 34 de contrôle d'un courant circulant entre les deux bornes 24 et 26 de chaque ligne de courant 32 de l'équipement 2. Le module 34 commande l'électroaimant 28de façon à ouvrir et fermer sélectivement les lignes de courant 32 de l'équipement 2 par déplacement des palettes 33. Ce module 34 comprend un tore de Rogowski 36 associé à divers composants électroniques dont certains sont visibles aux figures 2 et 3 avec la référence 38 et qui comprennent, entre autres, un microprocesseur.

Les composants 38 sont montés sur une carte de circuit imprimé 40, parfois dénommée PCB de l'anglais « Printed Circuit Board ».

La carte 40 est reliée électriquement aux bornes 30 du contacteur 3, par un ou plusieurs conducteurs électriques non représentés, afin de contrôler l'état de l'électroaimant 28 et de le commander.

En pratique, le boîtier 22 est bipartite, avec une première partie 22a formée par le châssis 29 et une deuxième partie 22b qui renferme le module de contrôle 34. Ces parties 22a et 22b sont solidarisées entre elles par encliquetage et vissage.

En variante non représentée, la partie 22a du boîtier 22 enveloppe le châssis 29. Selon une autre variante non représentée, le boîtier 22 est monobloc.

Le boîtier 22 est monté sur le rail 4 grâce à un crochet 42 ménagé sur l'arrière de la partie du boîtier 22 formée par le châssis 29, c'est-à-dire du côté opposé à la face avant du contacteur 2 qui est visible à la figure 1. Le crochet 42 vient en engagement avec une première bordure 4a du rail 4, à savoir sa bordure inférieure.

Par ailleurs, deux ressorts spirales 44 sont montés dans le boîtier 22 et viennent en prise avec une deuxième bordure 4b du rail 4, à savoir sa bordure supérieure. Les deux ressorts spirales 44 sont reçus dans des logements 46 ménagés à cet effet sur l'arrière du boîtier 22.

Dès lors que le contacteur 2 est monté sur le rail 4, les ressorts 44 viennent se coincer en arrière de la bordure 4b contre laquelle ils viennent en appui, ce qui permet de retenir en position le contacteur 2 sur le rail 4.

Les ressorts 44 peuvent se déformer élastiquement lors de la mise en place du contacteur 2 sur le rail 4 ou lors de son retrait. En d'autres termes, les ressorts 44 permettent un encliquetage élastique réversible du contacteur 2 sur le rail 4.

Comme le rail 4 est mis à la terre en application des normes en vigueur, chaque ressort 44 est également mis à la terre lorsqu'il est en appui contre ce rail, en tenant compte du fait que ce ressort 44 est réalisé en métal, par exemple en acier, donc électriquement conducteur.

Afin d'éviter que des perturbations électromagnétiques externes viennent perturber le fonctionnement des composants électroniques 38 ou du tore de Rogowski 36, au moins une borne de masse 48 de la carte de circuit imprimé 40 est mise à la terre en étant reliée électriquement au rail 4.

En pratique, deux bornes de mise à la terre de la carte de circuit imprimé 40 sont reliées électriquement au rail 4. Ceci n'est toutefois pas obligatoire et une seule borne 48 peut être mise à la terre de cette façon, en fonction de la taille de la carte de circuit imprimé et du nombre et du type des composants 38 qu'elle supporte.

Pour ce faire, une agrafe 50 réalisée par un fil de bronze est intégrée au boîtier 22 pour venir en appui, d'une part, contre une borne de masse 48 et, d'autre part, contre un ressort 44. Il est prévu autant d'agrafes 50 que de bornes de masse 48 à relier au rail 4. Ces agrafes sont identiques.

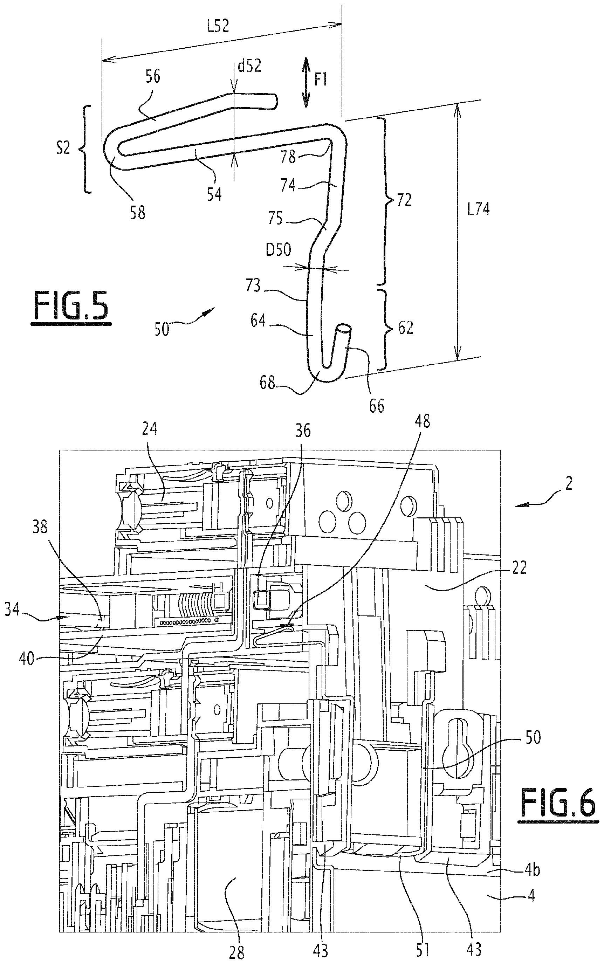

Une agrafe 50 est visible seule en perspective à la figure 5. Elle est réalisée par un fil de bronze conformé avec une géométrie adaptée à sa fonction, qui présente une section circulaire dont le diamètre D50 est compris entre 0,5mm et 2mm. En pratique, le fil de bronze utilisé pour constituer l'agrafe 50 peut avoir une section autre que circulaire. Dans tous les cas, la section de ce fil présente une aire comprise entre 0,5mm² et 4mm² mm².

En variante, le fil métallique utilisé pour constituer l'agrafe 50 peut être réalisé dans un matériau autre que du bronze, par exemple en acier cuivré, cuivre, laiton ou tous les matériaux en alliage de cuivre

Quel que soit le matériau utilisé, le fil métallique constituant l'agrafe 50 est semi-rigide, en ce sens qu'il peut être conformé pour prendre la géométrie représentée à la figure 5, tout en étant élastiquement déformable afin de s'adapter à son environnement, notamment à la position et à la géométrie des pièces contre lesquelles il est en appui.

L'agrafe 50 comprend une première portion 52 d'appui mécanique élastique contre la borne de masse 48. La première portion 52 est formée d'une première branche rectiligne 54 et d'une deuxième branche 56 bombée à l'opposé de la branche 54. Les branches 54 et 56 sont reliées par un coude de jonction 58 qui peut se déformer élastiquement, ce qui donne à la branche 56 une possibilité de mouvement de rapprochement/éloignement par rapport à la branche 54, comme représenté par la double flèche F1 à la figure 5.

Les branches 54 et 56 s'étendent en divergeant l'une par rapport à l'autre à partir du coude 58 qui définit un angle compris entre 150 et 175°. Quand l'agrafe 50 est montée dans la boîte 22, la borne de masse est en appui mécanique élastique et en contact électrique direct avec la première portion 52 de l'agrafe 50.

Par ailleurs, l'agrafe 50 comprend une deuxième portion 62 d'appui élastique contre le ressort 44. Cette deuxième portion 62 comprend deux branches 64 et 66 reliées par un coude 68 qui s'engage partiellement dans le ressort 44, comme visible aux figures 3 et 4, en configuration assemblée du contacteur 2.

Dans cette configuration, la deuxième portion 62 de l'agrafe 50 est en contact mécanique élastique et en contact électrique direct avec le ressort 44.

L'agrafe 50 comprend également une troisième portion 72 qui relie entre elles les première et deuxième portions 52 et 62. Cette troisième portion 72 est de forme globalement allongée et ondulée, avec deux branches parallèles 73 et 74 reliées par une branche 75 non parallèle aux branches 73 et 74.

Un coude 78 globalement à angle droit relie les première et troisième portions 72. Ainsi, les deuxième et troisième portions 62 et 72 sont globalement perpendiculaires à la première portion 52.

La branche 73 prolonge la branche 64, alors que la branche 74 se raccorde sur le coude 78.

Comme cela ressort de la figure 4, le boîtier 22 définit deux rails creux 74 dont le volume intérieur V74 est configuré pour recevoir et guider la première portion 52 d'une agrafe 50 parallèlement à la longueur L52 de cette portion mesurée entre les coudes 58 et 78. Ainsi, la première portion 52 d'une agrafe 50 peut être engagée dans le volume V74 d'un rail 74 par coulissement dans le sens de la flèche F2 à la figure 4.

La géométrie du volume V74 peut être prévue de telle sorte que, lorsque le coude 78 vient en appui contre le bord du rail 74, la partie la plus externe de la branche 56 est en contact électrique avec la borne de masse 48 située en regard. On note d74 la distance entre le fond du volume V74 d'un rail 74 et la surface en regard S40 de la carte de circuit imprimé 40. On note d52 la distance maximale entre les côtés opposés des branches 54 et 56 sans contrainte, c'est-à-dire lorsque l'agrafe 50 est située à l'extérieur du boîtier 22. La distance d52 est choisie strictement supérieure à la distance d74, ce qui garantit un bon contact électrique entre la branche 56 et la borne de masse 48 lorsque la première portion 52 de l'agrafe 50 est en place dans le volume V74.

Par ailleurs, la longueur L74 de l'agrafe 50 mesurée entre les coudes 68 et 78 est choisie de telle sorte que, lorsque la première portion 52 est en place dans le volume V74, le coude 78 est engagé dans et en contact avec le ressort 44 adjacent. La distance d52 et la longueur L74 sont mesurées parallèlement l'une à l'autre.

La géométrie de l'agrafe 50 lui permet également de rattraper les tolérances de fabrication et les variations dimensionnelles qui pourraient avoir une influence sur le positionnement relatif des pièces 44 et 48 et sur les contacts électriques au niveau des portions 52 et 62. Ainsi, le contact électrique entre les parties 44 et 48, établi par l'agrafe 50, est pérenne dans une série de contacteurs 2 et stable dans le temps.

L'agrafe 50 permet de raccorder électriquement les pièces 44 et 48 en permanence, c'est-à-dire quelle que soit la position du ressort 44 par rapport au rail 4, du moment que l'équipement 2 est monté sur le rail 4.

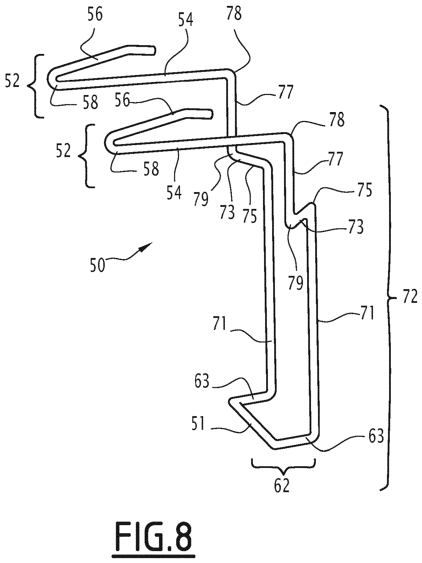

Dans le deuxième mode de réalisation de l'invention représenté aux figures 6 à 8, les éléments analogues à ceux du premier mode de réalisation portent les mêmes références. Dans ce qui suit, on décrit principalement ce qui distingue ce mode de réalisation du précédent.

Dans ce mode de réalisation, le boîtier 22 du contacteur 2 est immobilisé sur le rail 4 au moyen d'une agrafe élastique 50 qui comprend un barreau 51 destiné à venir en appui mécanique élastique direct avec la deuxième bordure supérieure 4b du rail 4, en étant parallèle à cette bordure. Ce barreau 51 forme un organe d'appui élastique et de contact électrique de l'agrafe 50 sur le rail 4.

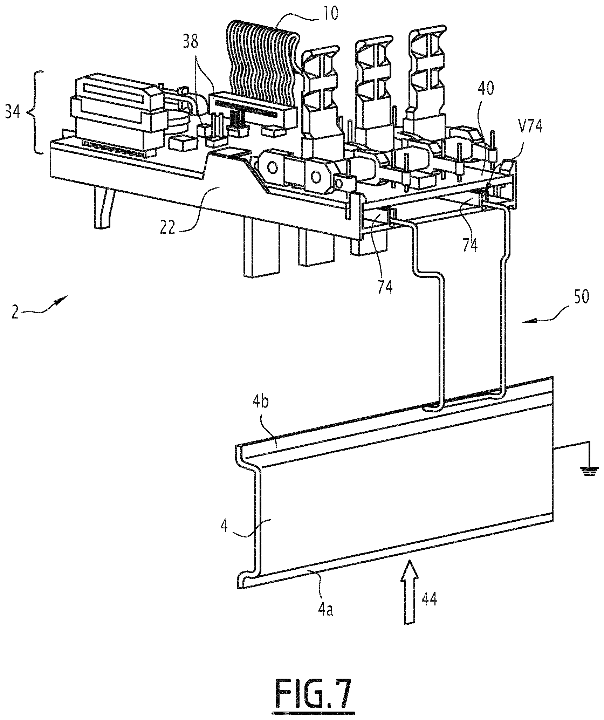

Un ou plusieurs organes élastiques, comparables aux ressorts 44 du premier mode de réalisation ou réalisés sous la forme de tiroirs mobile transversalement à un axe longitudinal du rail 4, sont prévus pour encliqueter le corps 22 sur le rail 4. Ces organes élastiques ne sont pas visibles à la figure 6 car situés en dessous de la limite inférieure de cette figure. A la figure 7, la flèche 44 représente la position d'un de ces organes élastiques. Ainsi l'agrafe 50 ne constitue pas, à elle seule, un organe de blocage élastique du boîtier 22 sur le rail 4, même si elle peut contribuer à ce blocage.

Le barreau 51 est disposé, le long du rail 4, entre deux crochets 43 de retenue du corps 22 sur le rail 4, ces crochets étant formés par le corps 22, sur l'arrière de celui-ci. Ces crochets viennent également en appui contre, ou à tout le moins en regard de, la deuxième bordure supérieure 4b.

Ces crochets analogues 43 sont comparables au crochet 42 du premier mode de réalisation

Dans ce mode de réalisation, l'agrafe 50 comprend deux premières portions 52 dont la géométrie est comparable à la première portion 52 de l'agrafe 50 du premier mode de réalisation, avec chacune une première branche 54, une deuxième branche 56 et un coude 58.

La deuxième branche 56 de chaque première portion vient en appui contre une borne de masse 48 d'une carte de circuit imprimé 40 qui appartient à un module de contrôle et/ou de commande 34 comparable à celui du premier mode de réalisation et qui supporte également un tore de Rogowski 36.

Des rails 74 de réception des premières portions 52 sont prévus, avec la même géométrie que dans le premier mode de réalisation.

L'agrafe 50 de ce deuxième mode de réalisation comprend également une deuxième portion 62 qui inclut, outre le barreau 51, deux branches 63 perpendiculaires à ce barreau et qui s'étendent du même côté de celui-ci, à partir de ces extrémités. Cette deuxième portion vient en appui contre, donc en contact électrique avec, le rail 4

Par ailleurs, une troisième portion 72 de l'agrafe 50 de ce mode de réalisation relie entre elles les deux premières portions 52 et la deuxième portion 62. Cette troisième portion 72 comprend deux branches 71 perpendiculaires au barreau 51 et aux branches 63, deux branches 73 reliées aux branches 71 par des coudes 75 à angle droit et deux branches 77 reliées aux branches 73 par des coudes 79 à angle droit. Les branches 77 sont parallèles à et décalées latéralement par rapport aux branches 71.

Des coudes 78 à angle droit relient les branches 77 aux deux premières portions 52 de cette agrafe 50.

Une différence importante entre ce deuxième mode de réalisation et le précédent est que, dans ce cas, l'agrafe 50 n'assure pas une fonction de blocage élastique du corps 22 sur le rail 4, ou du moins pas à elle seule, du fait des crochets 43 et de ceux représentés par la flèche 44 à la figure 7. De par son appui élastique contre le rail 4b, grâce au barreau 51, l'agrafe 50 est en contact électrique franc avec ce rail. En configuration montée de l'équipement 2 sur le rail 4, elle assure une fonction de liaison électrique permanente, grâce aux parties 52 à 79, entre les bornes de masse de la carte 40 et le rail 4.

En outre, dans ce mode de réalisation, une seule agrafe 50 permet de relier deux bornes de masse, analogues aux bornes de masse 48 du premier mode de réalisation, avec le rail 4.

Quel que soit le mode de réalisation, le simple fait de monter le contacteur 2 sur le rail 4 résulte dans une mise à la masse permanente des bornes 48 de la carte de circuit imprimé 40, que cette mise à la masse ait lieu via un organe élastique de blocage tel qu'un ressort spiral, comme le ressort 44 du premier mode de réalisation, ou directement par le contact de l'agrafe 50 elle-même avec le rail 4, comme dans le deuxième mode de réalisation.

Quel que soit le mode de réalisation, le fait de réaliser l'agrafe 50 en conformant un fil métallique semi-rigide permet à cet élément de raccordement de cheminer dans des espaces clos, c'est-à-dire dans un environnement contraint, sans nuire à la compacité de l'équipement électrique 2.

L'invention est présentée ci-dessus pour une application dans le cadre d'un contacteur. Elle est toutefois applicable à d'autres équipements électriques destinés à être montés sur un rail, qui comprennent un module de contrôle et/ou de commande, notamment à un module de mesure, tel que ceux représentés en tant que troisième et quatrième équipements 2 en partant de la gauche à la figure 1, à un disjoncteur ou un autre dispositif de contrôle et de protection.

Le rail 4 peut être conforme à un ou plusieurs standards autres que DIN.

Les modes de réalisation et variantes envisagés ci-dessus peuvent être combinés entre eux pour générer de nouveaux modes de réalisation de l'invention.

## Revendications

1. Equipement électrique (2) comprenant :
- un boîtier (22) destiné à être monté sur un rail (4) ;
- un module (34) de contrôle et/ou de commande incluant une carte de circuit imprimé (40),
**caractérisé en ce que**, en configuration montée de l'équipement électrique (2) sur le rail (4), au moins une borne de masse (48) de la carte de circuit imprimé (40) est raccordée électriquement au rail, en permanence, par appui mécanique élastique et contact électrique direct avec un élément de raccordement (50), lui-même en appui mécanique élastique et en contact électrique direct avec le rail ou avec un organe (44) de blocage élastique du boîtier sur le rail (4) et **en ce que** l'élément de raccordement est une agrafe conductrice semi-rigide (50) constituée par un fil métallique conformé pour relier électriquement la borne de masse (48) et le rail (4).

2. Equipement électrique selon la revendication 1, **caractérisé en ce que** l'agrafe conductrice semi-rigide (50) comprend une première portion (52) d'appui élastique contre la borne de masse (48) de la carte de circuit imprimé (40), cette première portion comprenant deux branches (54, 56) qui s'étendent à partir d'un coude de jonction (58).

3. Equipement électrique selon la revendication 2, **caractérisé en ce que** la première portion (52) d'appui élastique est reçue et guidée (F2), parallèlement à sa longueur (L52), dans un logement (V74) défini entre le boîtier (22) et la carte de circuit imprimé (40).

4. Equipement électrique selon l'une des revendications précédentes, **caractérisé en ce que** l'organe de blocage élastique est un ressort spiral (44) prévu pour venir en appui contre le rail (4) et **en ce que** l'agrafe conductrice semi-rigide (50) est en appui, d'une part, sur la borne de masse (48) et, d'autre part, sur le ressort spiral.

5. Equipement électrique selon la revendication 4, **caractérisé en ce que** l'agrafe conductrice est monobloc et conformée pour relier électriquement la borne de masse (48) de la carte de circuit imprimé (40) et le ressort spirale (44).

6. Equipement électrique selon les revendications 2 et 4 ou 2 et 5, **caractérisé en ce que** l'agrafe conductrice comprend une deuxième portion (62) d'appui élastique sur le ressort spirale (44), **en ce que** cette deuxième portion comprend deux branches (64, 66) qui s'étendent à partir d'un coude de jonction (68).

7. Equipement électrique selon l'une des revendications 1 à 3, **caractérisé en ce que** le fil métallique de l'agrafe conductrice semi-rigide (50) est monobloc et comprend :
- au moins une première portion (52) d'appui contre la borne de masse (48) de la carte de circuit imprimé (40) ;
- une deuxième portion (62) d'appui direct sur le rail (4) ; et
- une troisième portion (72) de liaison entre les première et deuxième portions.

8. Equipement électrique selon la revendication 7, **caractérisé en ce que**
- le fil métallique de l'agrafe conductrice semi-rigide (50) comprend deux premières portions (52) d'appui contre une borne (48) de la carte de circuit imprimé (40) ;
- la deuxième portion (62) du fil métallique de l'agrafe conductrice semi-rigide comprend un barreau d'appui mécanique élastique direct sur le rail (4) ; et
- la troisième portion (72) du fil métallique de l'agrafe conductrice semi-rigide relie entre elles les deux premières portions (52) et la deuxième portion (62).

9. Equipement électrique selon l'une des revendications précédentes, **caractérisé en ce que** l'agrafe conductrice semi-rigide est réalisée dans un fil de bronze, avec une section transversale dont l'aire est comprise entre 0.5 et 4 mm².

10. Procédé de mise à la terre d'une carte de circuit imprimé (40) d'un module (34) de contrôle et/ou de commande d'un équipement électrique (2) selon l'une des revendications précédentes, comprenant un boîtier (22) destiné à être monté sur un rail (4), **caractérisé en ce que** la mise à la terre est effectuée par le seul montage du boîtier (22) sur le rail (4).

## Patentansprüche

1. Elektrische Ausrüstung (2), umfassend:
- ein Gehäuse (22), das vorgesehen ist, an einer Schiene (4) montiert zu werden;
- ein Überwachungs- und/oder Steuermodul (34), das eine gedruckte Schaltungsplatte (40) einschließt,
**dadurch gekennzeichnet, dass** in der an der Schiene (4) montierten Konfiguration der elektrischen Ausrüstung (2) mindestens ein Masseanschluss (48) der gedruckten Schaltungsplatte (40) an die Schiene durch elastische mechanische Abstützung und direktem elektrischen Kontakt mit einem Anschlusselement (50), das selbst in elastischer mechanischer Abstützung und in direktem elektrischen Kontakt mit der Schiene oder mit einem Element (44) zur elastischen Arretierung des Gehäuses auf der Schienen (4) ist, ständig elektrisch angeschlossen ist und dass das Anschlusselement eine halbstarre leitende Klammer (50) ist, die aus einem Metalldraht besteht, der ausgebildet ist, den Masseanschluss (48) und die Schiene (4) elektrisch zu verbinden.

2. Elektrische Ausrüstung nach Anspruch 1, **dadurch gekennzeichnet, dass** die halbstarre leitende Klammer (50) einen ersten Abschnitt (52) zum elastischen Abstützen gegen den Masseanschluss (48) der gedruckten Schaltungsplatte (40) umfasst, wobei dieser erste Abschnitt zwei Arme (54, 56) umfasst, die sich von einem Verbindungsbogen (58) erstrecken.

3. Elektrische Ausrüstung nach Anspruch 2, **dadurch gekennzeichnet, dass** der erste Abschnitt (52) zum elastischen Abstützen parallel zu seiner Länge (L52) in einem Aufnahmeraum (V74) aufgenommen und geführt (F2) ist, der zwischen dem Gehäuse (22) und der gedruckten Schaltungsplatte (40) begrenzt ist.

4. Elektrische Ausrüstung nach einem der vorhergehenden Ansprüche, **dadurch gekennzeichnet, dass** das Element zum elastischen Arretieren eine Spiralfeder (44) ist, die vorgesehen ist, in Abstützung gegen die Schiene (4) zu kommen, und dass die halbstarre leitende Klammer (50) sich einerseits an dem Masseanschluss (48) und andererseits an der Spiralfeder abstützt.

5. Elektrische Ausrüstung nach Anspruch 4, **dadurch gekennzeichnet, dass** die leitende Klammer einstückig ist und ausgebildet ist, den Masseanschluss (48) der gedruckten Schaltungsplatte (40) und die Spiralfeder (44) elektrisch zu verbinden.

6. Elektrische Ausrüstung nach den Ansprüchen 2 und 4 oder 2 und 5,
**dadurch gekennzeichnet, dass** die leitende Klammer einen zweiten Abschnitt (62) zur elastischen Abstützung an der Spiralfeder (44) umfasst, dass dieser zweite Abschnitt zwei Arme (64, 66) umfasst, die sich von einem Verbindungsbogen (68) erstrecken.

7. Elektrische Ausrüstung nach einem der Ansprüche 1 bis 3, **dadurch gekennzeichnet, dass** der Metalldraht der halbstarren leitenden Klammer (50) einstückig ist und umfasst:
- mindestens einen ersten Abschnitt (52) zum Abstützen gegen den Masseanschluss (48) der gedruckten Schaltungsplatte (40);
- einen zweiten Abschnitt (62) zum direkten Abstützen an der Schiene (4); und
- einen dritten Abschnitt (72) zum Verbinden des ersten und des zweiten Abschnitts.

8. Elektrische Ausrüstung nach Anspruch 7, **dadurch gekennzeichnet, dass**
- der Metalldraht der halbstarren leitenden Klammer (50) zwei erste Abschnitte (52) zum Abstützen gegen einen Anschluss (48) der gedruckten Schaltungsplatte (40) umfasst;
- der zweite Abschnitt (62) des Metalldrahtes der halbstarren leitenden Klammer einen Stab zum mechanischen elastischen direkten Abstützen an der Schiene (4) umfasst; und
- der dritte Abschnitt (72) des Metalldrahtes der halbstarren leitenden Klammer die zwei ersten Abschnitte (52) und den zweiten Abschnitt (62) untereinander verbindet.

9. Elektrische Ausrüstung nach einem der vorhergehenden Ansprüche, **dadurch gekennzeichnet, dass** die halbstarre leitende Klammer aus einem Bronzedraht mit einem Querschnitt, dessen Fläche zwischen 0,5 und 4 mm² beträgt, hergestellt ist.

10. Verfahren zum Erden einer gedruckten Schaltungsplatte (40) eines Überwachungs- und/oder Steuermoduls (34) einer elektrischen Ausrüstung (2) nach einem der vorhergehenden Ansprüche, das ein Gehäuse (22) umfasst, das vorgesehen ist, auf einer Schiene (4) montiert zu werden, **dadurch gekennzeichnet, dass** das Erden durch eine einzige Montage des Gehäuses (22) an der Schiene (4) durchgeführt wird.

## Claims

1. Electrical equipment (2) comprising:
- a housing (22) which is to be mounted on a rail (4);
- a control and/or command module (34) including a printed circuit board (40),
**characterised in that**, in the mounted configuration of the electrical equipment (2) on the rail (4), at least one ground terminal (48) of the printed circuit board (40) is permanently electrically connected to the rail by resilient mechanical abutment and direct electrical contact with a connection element (50), which is itself in resilient mechanical abutment on and in direct electrical contact with the rail or with a member (44) for resiliently locking the housing on the rail (4), and **in that** the connection element is a semi-rigid conductive clip (50) constituted by a metal wire which is shaped to electrically connect the ground terminal (48) and the rail (4).

2. Electrical equipment according to claim 1, **characterised in that** the semi-rigid conductive clip (50) comprises a first portion (52) for resilient abutment against the ground terminal (48) of the printed circuit board (40), said first portion comprising two branches (54, 56) which extend from a joining bend (58).

3. Electrical equipment according to claim 2, **characterised in that** the first resilient abutment portion (52) is received and guided (F2), parallel to its length (L52), in a receiver (V74) defined between the housing (22) and the printed circuit board (40).

4. Electrical equipment according to any one of the preceding claims, **characterised in that** the resilient locking member is a spiral spring (44) which is provided to come into abutment against the rail (4), and **in that** the semi-rigid conductive clip (50) is in abutment on the one hand on the ground terminal (48) and on the other hand on the spiral spring.

5. Electrical equipment according to claim 4, **characterised in that** the conductive clip is in one piece and shaped to electrically connect the ground terminal (48) of the printed circuit board (40) and the spiral spring (44).

6. Electrical equipment according to claims 2 and 4 or 2 and 5, **characterised in that** the conductive clip comprises a second portion (62) for resilient abutment on the spiral spring (44), **in that** said second portion comprises two branches (64, 66) which extend from a joining bend (68).

7. Electrical equipment according to any one of claims 1 to 3, **characterised in that** the metal wire of the semi-rigid conductive clip (50) is in one piece and comprises:
- at least one first portion (52) for abutment against the ground terminal (48) of the printed circuit board (40);
- a second portion (62) for direct abutment on the rail (4); and
- a third joining portion (72) between the first and second portions.

8. Electrical equipment according to claim 7, **characterised in that**:
- the metal wire of the semi-rigid conductive clip (50) comprises two first portions (52) for abutment against a terminal (48) of the printed circuit board (40);
- the second portion (62) of the metal wire of the semi-rigid conductive clip comprises a bar for direct resilient mechanical abutment on the rail (4); and
- the third portion (72) of the metal wire of the semi-rigid conductive clip connects together the two first portions (52) and the second portion (62).

9. Electrical equipment according to any one of the preceding claims, **characterised in that** the semi-rigid conductive clip is produced from a bronze wire having a cross-section the area of which is between 0.5 and 4 mm².

10. Method for grounding a printed circuit board (40) of a control and/or command module (34) of electrical equipment (2) according to any one of the preceding claims, comprising a housing (22) which is to be mounted on a rail (4), **characterised in that** the grounding is carried out simply by mounting the housing (22) on the rail (4).
